# EUROPÄISCHE PATENTSCHRIFT

(11) **EP 1 478 249 B1**
(45) Veröffentlichungstag und Bekanntmachung des Hinweises auf die Patenterteilung: **18.07.2007**
(21) Anmeldenummer: 02806316.2
(22) Anmeldetag: 04.12.2002
(51) Int. Cl.: A41D 31/00

(54) **VERFAHREN UND VORRICHTUNG ZUR INTEGRATION VON ELEKTRONIK IN TEXTILIEN**
METHOD AND DEVICE FOR INTEGRATING ELECTRONICS IN TEXTILES
PROCEDE ET DISPOSITIF D'INTEGRATION D'ELECTRONIQUE DANS DES TEXTILES

(30) Priorität: 21.01.2002 DE 10202123
(43) Veröffentlichungstag der Anmeldung: 24.11.2004
(73) Patentinhaber: Infineon Technologies AG, 81669 München (DE)
(72) Erfinder: JUNG, Stefan, 80469 München (DE); LAUTERBACH, Christl, 85635 Höhenkirchen-Siegertsbrunn (DE)
(74) Vertreter: Rocke, Carsten
(86) Internationale Anmeldenummer: PCT/EP2002/013746
(87) Internationale Veröffentlichungsnummer: WO 2003/059101

(56) Entgegenhaltungen:
- JP-A- 61 198 798
- US-A- 3 631 298
- US-A- 6 080 690
- US-B1- 6 210 771
- US-B1- 6 243 870

## Beschreibung

Die Erfindung betrifft eine Vorrichtung gemäß Anspruch 1 sowie ein Verfahren gemäß Anspruch 13.

Die Integration elektronischer Systeme in textile Umgebungen hat in jüngerer Zeit eine wachsende Bedeutung erlangt. Beispielsweise ist ein zunehmendes Bedürfnis nach textiler Bekleidung und Accessoires zu verzeichnen, welche außer ihren traditionellen Funktionen, wie Wärme- bzw. Schutzwirkung und Statussymboleigenschaften, auch zusätzliche Funktionen wie Gesundheitsführsorge, persönliche Sicherheit und Kommunikation erfüllen können. Zahlreiche denkbare Anwendungen "intelligenter Kleidung" (smart clothes) können durch die Integration von elektronischen Bauelementen und elektronischen Modulen in Textilien realisiert werden.

Bisherige Ansätze, Elektronik in textile Umgebungen zu integrieren beschränken sich auf das Einnähen von handelsüblichen elektronischen Modulen, wie beispielsweise das Einnähen von elektronischen Kleinrechnern (Palmtops, Mobiltelefonen, GPS-Systemen oder MP3-Abspielgeräten) und das "Verlegen" von konventionellen Verbindungskabeln in "textilen Kabelkanälen" in eigens dafür konfektionierter Bekleidung. Derartige Integrationsversuche elektronischer Bauelemente in textile Umgebungen führen jedoch zu einer erheblichen Beeinträchtigung der Gebrauchseigenschaften des Textils. So tragen die handelsüblichen elektronischen Module in der textilen Umgebung auf und versteifen in störender Weise das ansonsten flexible textile Material. Ferner gestatten derartige Integrationsmaßnahmen es nicht, daß die resultierenden Produkte einer herkömmlichen Textilpflege unterzogen werden. Insbesondere sind derartige Produkte gegenüber einem Wasch-, Reinigungs- und Bügelvorgang nicht widerstandsfähig.

WO 01/95752 A1 offenbart ein Kleidungsstück, in welches elektronische Vorrichtungen integriert sind, wobei das Kleidungsstück ein oder mehrere elektrische Leiter umfaßt, welche mit den elektronischen Geräten verbindbar sind und wobei die elektronischen Geräte in Taschen des Kleidungsstücks untergebracht sind.

US-B1-6 210 771 offenbart Gewebe, in welches elektronische Schaltkreise integriert sein können, wobei das Gewebe leitfähige Fasern umfaßt, welche entlang einer Weberichtung verlaufen und nicht leitfähige Fasern umfaßt, welche entgegen der Weberichtung verlaufen.

Aufgabe der Erfindung ist es, eine Vorrichtung anzugeben, welche eine verbesserte Integration elektronischer Bauelemente in eine textile Umgebung gestattet. Aufgabe ist ferner, ein entsprechendes Verfahren zum Verbinden eines elektronischen Bauelements mit einem textilen Material anzugeben.

Diese Aufgabe wird durch eine Vorrichtung mit den Merkmalen von Anspruch 1 bzw. durch ein Verfahren mit den Merkmalen von Anspruch 13 gelöst. Bevorzugte Ausführungsformen sind Gegenstand der abhängigen Ansprüche.

Erfindungsgemäß umfaßt eine Vorrichtung
- zumindest ein textiles Material, in welchem zumindest ein flexibler, draht- und/oder fadenartiger elektrischer Leiter angeordnet ist;
- zumindest ein elektronisches Bauelement, welches zumindest eine elektrisch leitfähige Kontaktstelle aufweist, die mit dem Leiter elektrisch verbunden ist;
- zumindest eine erste harte Kapselung, welche zumindest die Kontaktstelle des Bauelements abdeckt und mechanisch stabilisiert; und
- zumindest eine zweite Kapselung, welche derart ausgelegt ist, daß sie eine mechanische Verbindung des Bauelements mit dem textilen Material ermöglicht, wobei
die zweite Kapselung ein Silikon, ein Polyurethan und/oder einen Textilkleber, vorzugsweise einen Schmelzkleber, insbesondere einen Schmelzkleber auf Copolyamid- oder Copolyesterbasis umfaßt.

Bei dem elektronischen Bauelement, welches in die textile Umgebung integriert werden soll, kann es sich beispielsweise um eine ein- oder mehrlagige Epoxy-Leiterplatte, eine Keramikplatte oder ähnliches handeln, welche ein- oder beidseitig mit elektronischen Komponenten, Leiterbahnen sowie Kontaktstellen für Spannungsversorgung und Datenein- und - ausgabe bestückt ist. Damit das elektronische Bauelement möglichst klein ist und nur eine geringe Fläche des textilen Materials versteift, wird es - falls notwendig - vorzugsweise doppelseitig bestückt. Die zumindest eine Kontaktstelle des elektronischen Bauelements ist elektrisch leitfähig mit dem zumindest einen flexiblen, draht- und/oder fadenartigen elektrischen Leiter des textilen Materials verbunden.

Die Erfindung schlägt einen Aufbau mit zwei Kapselungen vor, um das Bauelement mit dem textilen Material so zu verbinden, daß die erfindungsgemäße Vorrichtung typischen Gebrauchsbelastungen widerstehen kann. Die erste harte Kapselung ist insbesondere in einem Kontaktstellenbereich des elektronischen Bauelements vorgesehen, um die elektrische Verbindung der Kontaktstelle mit einer Leiterbahn oder einem Metalldraht insbesondere hinsichtlich mechanischer Belastungen zu schützen. Da elektronische Bauelemente typischerweise starre Trägermaterialien wie Leiterplatten oder Halbleiterplättchen umfassen, das textile Material jedoch flexible Eigenschaften aufweist, ist die Übergangsstelle zwischen starrem Bauelement und flexiblem Material besonders beansprucht. Die erste Kapselung führt vorzugsweise auch zu einer wasserfesten Versiegelung des Kontaktstellenbereichs.

Die zweite Kapselung, welche wie die erste Kapselung das Bauelement nicht vollständig umgeben muß, hat seine Hauptfunktion hingegen nicht in einem mechanischen und gegebenenfalls chemischen Schutz des Kontaktstellenbereichs. Stattdessen ist die zweite Kapselung derart ausgelegt, daß sie eine einfache und sichere mechanische Verbindung des Bauelements mit dem textilen Material ermöglicht. Somit sind die Anforderungen, welche an die zweite Kapselung zu stellen sind, von denjenigen der ersten Kapselung verschieden, so daß für die Zwecke der mechanischen Verbindung zwischen dem Bauelement und dem textilen Material geeignetere Materialien gewählt werden können.

Vorzugsweise umgibt die erste Kapselung das Bauelement vollständig. Wenn das Bauelement beispielsweise eine mit elektronischen Komponenten bestückte Leiterplatte ist, so umgibt die erste Kapselung sowohl die elektronischen Komponenten als auch die Kontaktstellen des Bauelements, an welche elektrische Leiterbahnen bzw. elektrisch leitfähige Drähte angeschlossen sind. Eine derartige vollständige Kapselung des elektronischen Bauelements mit dem Anschlußbereich der elektrischen Zuleitungen gewährleistet eine hohe mechanische und chemische Widerstandsfähigkeit der erfindungsgemäßen Vorrichtung.

Vorzugsweise umgibt die zweite Kapselung das Bauelement mit der ersten Kapselung vollständig. Das Bauelement, welches beispielsweise nur in dessen Kontaktstellenbereichen mit der ersten harten Kapselung umgeben ist, wird somit bevorzugt vollständig von der zweiten Kapselung umgeben. Da die zweite Kapselung derart ausgelegt ist, daß sie eine einfache mechanische Verbindung des enthaltenen Bauelements mit dem textilen Material ermöglicht, gestattet die vollständige zweite Kapselung eine besonders gute Integrationsmöglichkeit in die textile Umgebung.

Vorzugsweise ist das elektronische Bauelement über ein Flexband mit dem Leiter elektrisch verbunden. Bei dem Flexband handelt es sich um eine dünne, flexible Isolatorfolie, auf welche elektrisch leitfähige Leiterbahnen beispielsweise aufgedruckt oder aus einer ursprünglich ganzflächigen Metallisierung durch Fototechnik und anschließende Ätztechnik strukuriert wurden. Die Kontaktstelle des elektronischen Bauelements wird elektrisch mit einer derartigen Leiterbahn verbunden, welche ihrerseits mit dem Leiter des textilen Materials verbunden werden kann. Der Kontaktstellenbereich der Kontaktstelle mit der Leiterbahn des Flexbands wird durch die erste Kapselung gegenüber mechanischen und chemischen Einflüssen geschützt.

Gemäß einer weiteren bevorzugten Ausführungsform ist das elektronische Bauelement über einen flexiblen Metalldraht mit dem Leiter elektrisch verbunden. Dies ermöglicht vorteilhafterweise zum einen einen flexiblen Übergang des starren Bauelements zu dem flexiblen textilen Material, so daß keine unnötig großen Flächenbereiche des textilen Materials versteift werden müssen. Zum anderen eröffnet die elektrische Verbindung zwischen Kontaktstelle und Leiter des textilen Materials vielfältige Anschlußfreiheitsgrade bei dem Anschluß an die Leiter des textilen Materials und ermöglicht so eine einfache Anpassung des Anschlußrasters des elektronischen Bauelements mit einem gewählten Anordnungsmuster der flexiblen Leiter in dem textilen Gewebe. Da die typische Leiterperiode in dem textilen Gewebe typischerweise zumindest eine Größenordnung größer als typische Kontaktstellenperioden elektronischer Bauelemente ist, gestattet die elektrische Verbindung mittels flexibler Metalldrähte eine einfache Aufweitung und Anpassung der Anschlußstellenperioden.

Bevorzugt weist der Metalldraht einen Durchmesser im Bereich von 50 µm bis 200 µm auf. Mit Vorteil kann ein Metalldraht eingesetzt werden, welcher eine Isolierummantelung aufweist. Besonders bevorzugt weist der Metalldraht eine derartige Isolierummantelung auf, welche eine Schmelz- bzw. Zersetzungstemperatur hat, die niedriger als eine typische Löttemperatur, insbesondere niedriger als 350°C ist. Kommt ein derartiger Metalldraht zum Einsatz, so kann auf eine gesonderte elektrische Abisolierung des Drahtes vor einem elektrischen Verbindungsschritt verzichtet werden, sofern dieser als thermischer Verbindungsschritt (Lötschritt) ausgeführt wird. Bei der elektrischen Verbindung des Metalldrahts mit der Kontaktstelle wird die elektrische Isolierummantelung thermisch zerstört, so daß ein elektrischer Kontakt entstehen kann. Besonders bevorzugt ist der Metalldraht ein sogenannter Fädeldraht, wie er aus der Fädeltechnik bekannt ist.

Gemäß einer bevorzugten Ausführungsform umfaßt die erste harte Kapselung einen Zweikomponentenlack oder -kleber, einen Polyesterlack, einen PU-Lack, einen Globetop, einen Spritzkunststoff und/oder einen hochschmelzenden Schmelzkleber. Die obengenannten Materialien haben sich als besonders geeignet für die mechanische Stabilisierung sowie den chemischen Schutz des Kontaktstellenbereichs des Bauelements erwiesen.

Gemäß der Erfindung umfaßt die zweite Kapselung einen Textilkleber, vorzugsweise einen Schmelzkleber, insbesondere einen Schmelzkleber auf Copolyamid- oder Copolyesterbasis. Im Unterschied zu der ersten harten Kapselung liegen die Hauptanforderungen an die zweite Kapselung nicht in dem mechanischen und/oder chemischen Schutz des Bauelements. Somit kann ein im Vergleich mit der ersten Kapselung weicherer Textilkleber zum Einsatz kommen, bei welchem es sich vorzugsweise um einen speziellen Textilkleber handelt. Der resultierende "Zweikapselungsaufbau" der erfindungsgemäßen Vorrichtung ist mechanisch, chemisch und thermisch erheblich widerstandsfähiger als ein "Einkapselaufbau".

Besonders bevorzugt umfaßt die zweite Kapselung einen Schmelzkleber, dessen Schmelztemperatur niedriger als die Schmelztemperatur der ersten harten Kapselung und höher als eine zugelassene Pflegetemperatur des textilen Materials liegt. Eine mechanische Verbindung des textilen Materials mit der zweiten Kapselung kann durch einen thermischen Festlegungsschritt gefahrlos erfolgen, ohne daß es zu negativen Einflüssen auf das Bauelement, insbesondere auf dessen Kontaktstellenbereich kommt. Da die Schmelztemperatur der zweiten Kapselung niedriger als die typische Pflegetemperatur des textilen Materials liegt, d.h. niedriger als typische Wasch-, Reinigungs- und Bügeltemperaturen ist, resultiert eine gegenüber typischen Gebrauchsbelastungen widerstandsfähige Vorrichtung. Alternativ zu den Textilklebern können auch weiche, biegsame Silikone oder Polyurethane verwendet werden.

Besonders bevorzugt weist das textile Material ein Gewebe mit zumindest einem elektrisch leitfähigen Schuß- und/oder Kettfaden auf und der Leiter umfaßt zumindest einen elektrisch leitfähigen Schuß- und/oder Kettfaden des Gewebes. Die Leiter sind somit direkt in das Gewebe als leitfähige Schuß- und/oder Kettfäden eingewebt und auf diese Weise optimal in die textile Umgebung integriert.

Gemäß der Erfindung umfaßt ein Verfahren zum Verbinden eines elektronischen Bauelements mit einem Textil die Schritte:
- Bereitstellen zumindest eines elektronischen Bauelements, welches zumindest eine elektrisch leitfähige Kontaktstelle aufweist;
- elektrisches Verbinden der Kontaktstelle mit einer Leiterbahn eines Flexbandes oder mit einem flexiblen Metalldraht;
- Anbringen zumindest einer ersten harten Kapselung an das Bauelement derart, daß zumindest die Kontaktstelle des Bauelements abgedeckt und mechanisch stabilisiert wird;
- Anbringen zumindest einer zweiten Kapselung an das Bauelement und/oder die erste Kapselung;
- Festlegen des Bauelements mittels der zweiten Kapselung an einem textilen Material, in welchem zumindest ein flexibler, draht- und/oder fadenartiger elektrischer Leiter angeordnet ist; und
- elektrisches Verbinden der Leiterbahn des Flexbandes bzw. des Metalldrahts mit dem draht- und/oder fadenartigen elektrischen Leiter,
wobei die zweite Kapselung ein Silikon, ein Polyurethan und/oder einen Textilkleber, vorzugsweise einen Schmelzkleber, insbesondere einen Schmelzkleber auf Copolyamid- oder Copolyesterbasis umfaßt.

Die Reihenfolge der erfindungsgemäßen Verfahrensschritte ist hierbei nicht fest vorgegeben. Beispielsweise kann die Leiterbahn des Flexbandes bzw. der Metalldraht mit dem flexiblen Leiter des textilen Materials elektrisch verbunden werden, bevor die zweite Kapselung erfolgt. Die in Zusammenhang mit den zuvor beschriebenen erfindungsgemäßen Vorrichtungen beschriebenen Merkmale können vorteilhafterweise ebenfalls in Verbindung mit dem erfindungsgemäßen Verfahren verwendet werden.

Die Erfindung wird nachfolgend mit Bezug auf begleitende Zeichnungen bevorzugter Ausführungsformen beispielhaft beschrieben. Es zeigt:
- Fig.1: eine schematische Auf- und Schnittansicht eines elektronischen Bauelements, welches in eine textile Umgebung integriert werden soll;
- Fig. 2.: das elektronische Bauelement von Fig.1 mit daran elektrisch verbundenen Metalldrähten;
- Fig. 3: das elektronische.Bauelement gemäß Fig. 1 mit angeschlossenen Metalldrähten umgeben von einer ersten harten Kapselung;
- Fig. 4: das gekapselte Bauelement von Fig. 3 mit einer zweiten Kapselung;
- Fig. 5: ein integrierter Schaltkreis mit erster und zweiter Kapselung; und
- Fig. 6: eine Ausführungsform einer erfindungsgemäßen Vorrichtung, wobei das textile Material ein Bandgewebe ist.

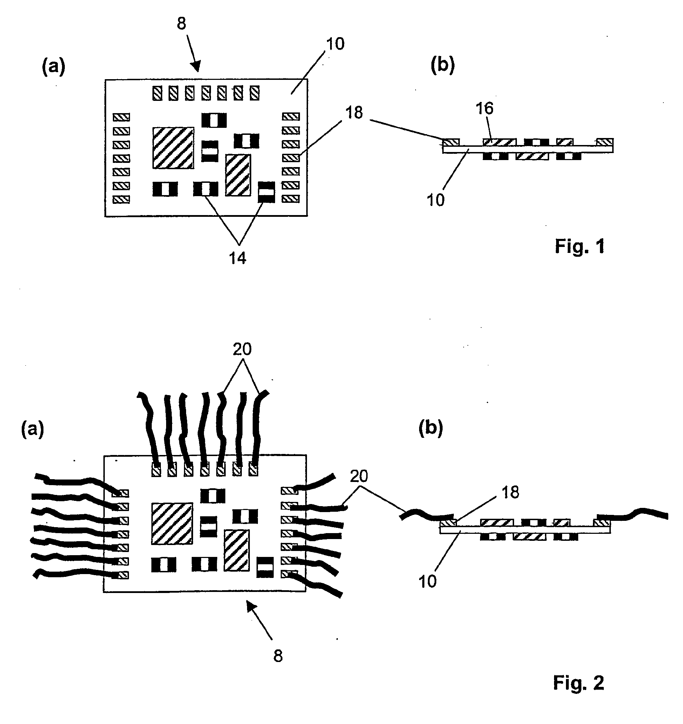

In Fig. 1 ist ein elektronisches Bauelement 8, welches in eine textile Umgebung integriert werden soll, in Aufsicht (a) und Schnittansicht (b) dargestellt. Das elektronische Bauelement 8 weist eine ein- oder mehrlagige Epoxy-Leiterplatte 10 auf. Gleichermaßen kann auch eine Keramikplatte oder eine ähnliche Tragvorrichtung zum Einsatz kommen. Auf der Leiterplatte 10 befinden sich beispielsweise eine Vielzahl passiver 14 und aktiver 16 Komponenten bzw. elektronischer Module. Die Spannungsversorgung sowie die Datenein- und -ausgabe erfolgt über eine Vielzahl von vorzugsweise regelmäßig beabstandeter Kontaktstellen 18, welche beispielsweise als Bondpads oder Lötplattformen ausgebildet sind. Vorzugsweise ist das elektronische Bauelement 8 möglichst klein, um so nur eine geringe Fläche in der textilen Umgebung zu versteifen, und wird - wie in der Schnitteinsicht Fig. 1(b) gezeigt - wenn nötig beidseitig bestückt.

In Fig. 2 ist in Aufsicht (a) und Schnittansicht (b) das elektronische Bauelement 8 gemäß Fig. 1 dargestellt, wobei dünne, flexible Metalldrähte 20 elektrisch leitfähig mit jeweiligen Kontaktstellen 18 verbunden sind. Die Drähte 20 weisen typischerweise eine Länge von einigen Millimetern bis einigen Zentimetern sowie Durchmesser von typischerweise 50 µm bis 200 µm auf. Das elektrische Verbinden der Metalldrähte 20 mit den Kontaktstellen 18 erfolgt vorzugsweise durch Löten, Punktschweißen, Ultraschallbonden oder Kleben mit leitfähigem Kleber. Vorzugsweise sind die Metalldrähte 20 mit einem Isolierlack überzogen, welcher sich bei typischen Löttemperaturen (ca. 350°C) selbstständig auflöst bzw. zersetzt. Derartige Metalldrähte 20 sind aus der sogenannten Fädeltechnik bekannt. Bei der Fädeltechnik werden Testschaltungen aus diskreten Bauteilen derart aufgebaut, daß die Kontaktstellen der Bauteile durch Anlöten von Fädeldraht miteinander verbunden werden.

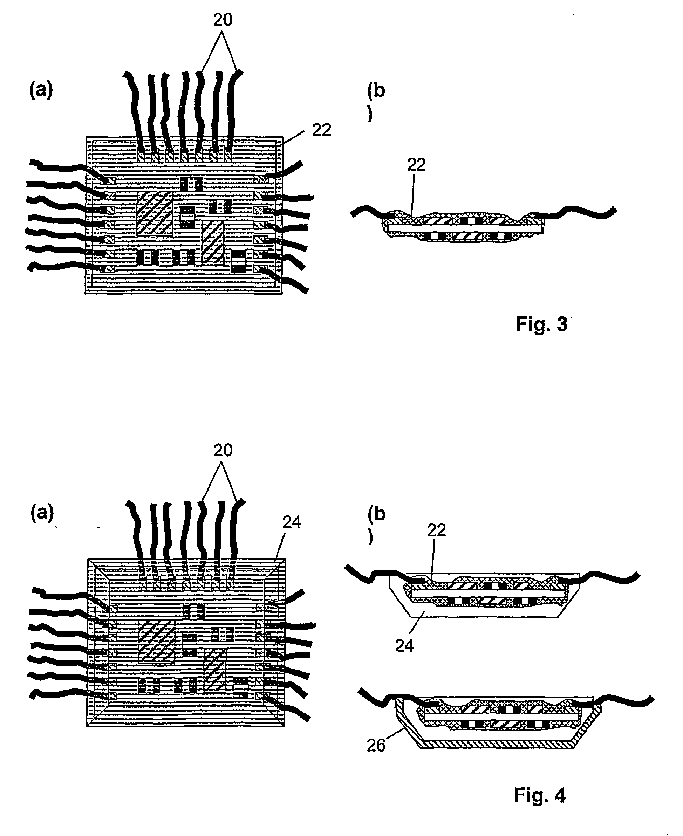

In Fig. 3 ist in Aufsicht (a) und Schnittansicht (b) das bereits in Figs. 1 und 2 dargestellte elektronische Bauelement 8 in dem nachfolgenden Prozeßschritt gezeigt. Das mit den Fädeldrähten 20 versehene elektronische Bauelement 8 wird mit einer vorzugsweise wasserfesten, harten Kapselung 22 versehen, welche vorzugsweise sämtliche Komponenten 14, 16 sowie die Kontaktstellen 18 abdeckt. Die erste, harte Kapselung 22 kann jedoch auch derart an dem elektronischen Bauelement 8 angebracht sein, daß sie lediglich die Kontaktstellen 18, mit welchen die Metalldrähte 20 elektrisch verbunden sind, abdeckt und mechanisch stabilisiert.

Aufgabe der ersten harten Kapselung 22 ist die mechanische und vorzugsweise chemische Stabilisierung des elektronischen Bauelements 8, so daß dessen Komponenten 14, 16 geschützt und vorzugsweise wasserfest versiegelt sind. Die erste Kapselung 22 umfaßt vorzugsweise einen Zweikomponentenlack oder - kleber, einen Polyesterlack, einen PU-Lack, einen sogenannten Globetop, welcher oftmals zur Versiegelung von Siliziumchips Verwendung findet, Spritzkunststoff und/oder hochschmelzenden Schmelzkleber. Typische Schichtdicken der ersten Kapselung 22 betragen einige Mikrometer bis typischerweise einige 100 Mikrometer.

In Fig. 4 ist in Aufsicht (a) und Schnittansicht (b) das elektronische Bauelement 8 nach dem nachfolgendem Prozeßschritt dargestellt, bei welchem das Bauelement 8 mit der bereits angebrachten ersten Kapselung 22 von einer zweiten Kapselung 24 umgeben ist. Die zweite Kapselung 24 umfaßt bevorzugt einen Schmelzkleber, der für textile Anwendungen ausgelegt ist. Bevorzugt wird der Schmelzkleber derart gewählt, daß seine Schmelztemperatur niedriger als die Schmelztemperatur der ersten harten Kapselung 22 des Moduls, aber höher als die für das fertige textile Material zugelassenen Wasch- und Bügeltemperaturen (typischerweise 110 bis 200°C) ist. Optional kann bei dem zweiten Verkapselungsschritt eine Textilabdeckung 26 angebracht werden, wozu vorzugsweise der textile Schmelzkleber der zweiten Kapselung 24 Verwendung findet.

Ihre Form erhält die zweite Kapselung 24 beispielsweise durch Einbringen in eine negative Gußform aus einem geeigneten Material, an welchem der Schmelzkleber nicht haftet. Als gut geeignet hat sich Teflon erwiesen. Die Schmelztemperatur des textilen Schmelzklebers wird so gewählt, daß sie über der vorgesehenen Bügeltemperatur liegt, der Stoff aber das Aufkleben noch unbeschadet übersteht. Als geeigneter Temperaturbereich hat sich für einen Polyesterstoff 110 bis 200°C erwiesen. Typischerweise wird die zweite Kapselung 24 mit einer Schichtdicke im Bereich von einigen Mikrometern bis einigen Millimetern aufgebracht. Statt der eigens vorgesehenen Textilabdeckung 26 kann auch ein Außen- bzw. Futterstoff eines Bekleidungsstücks zur Textilabdeckung verwendet finden.

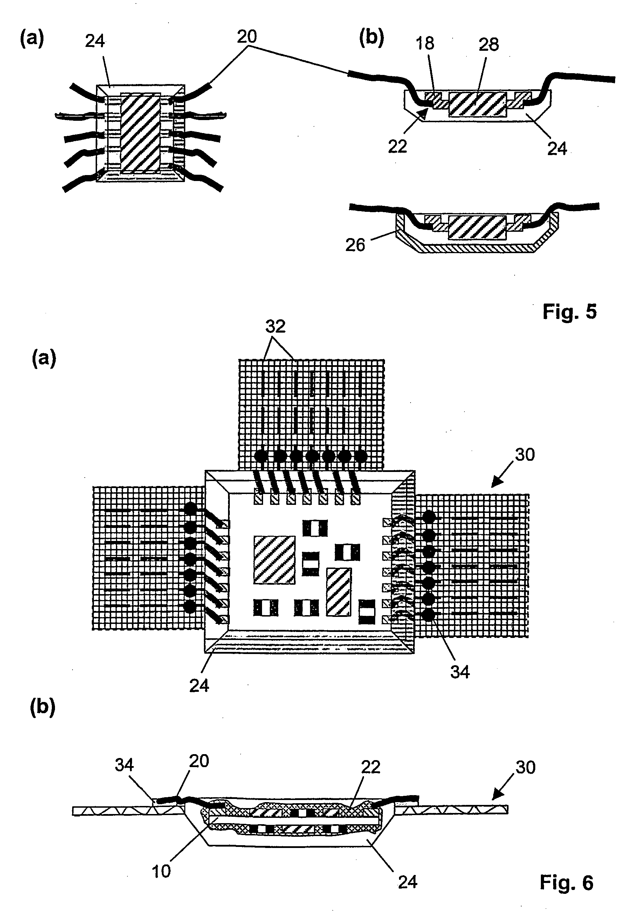

In Fig. 5 ist in Aufsicht (a) und Schnittansicht (b) eine weitere erfindungsgemäße Ausführungsform gezeigt. In diesem Fall besteht das elektronische Bauelement 8' nicht aus einer mit Komponenten bestückten Leiterplatte, sonders aus einem einzelnen integrierten Schaltkreis 28, welcher beispielsweise in einem SMD-Gehäuse verschweißt ist. An die Kontaktstellen bzw. -beinchen des SMD-Gehäuses werden die flexiblen Metalldrähte 20 angebracht. Die erste harte Kapselung erfolgt in diesem Fall vorzugsweise lediglich im Bereich der Kontaktstellen 18, um diese mechanisch und vorzugsweise auch chemisch zu stabilisieren. Der prozessierte Halbleiterchip, welcher sich in dem SMD-Gehäuse befindet, ist durch die SMD-Kapsel bereits hinreichend gegenüber Umwelteinflüssen geschützt. Jedoch kann auch bei den in Verbindung mit Figs. 1 bis 4 erläuterten Ausführungsformen die erste Kapselung 22 lediglich in dem Kontaktstellenbereich der Kontaktstellen 18 erfolgen. Wie bereits im Zusammenhang mit Fig. 4 erläutert, kann an der zweiten Kapselung 24 optional eine textile Abdeckung 26 angebracht werden, um dem integrierten elektronischen Bauelement 8' einen textilen "touch" zu geben. Wenn statt des integrierten Schaltkreises 8' ein Anzeigenelement (beispielsweise eine 7-Segmentanzeige oder eine LED) angebracht wird, entfällt die textile Abdeckung 26 und der textile Schmelzkleber der zweiten Kapselung 24 wird transparent und möglichst dünn aufgetragen gewählt.

In Fig. 6 ist in Aufsicht (a) und Schnittansicht (b) eine bevorzugte Ausführungsform einer erfindungsgemäßen Vorrichtung dargestellt. Das textile Material 30 ist in diesem Fall als Bandgewebe ausgestaltet, welches elektrisch leitfähige Kett- und/oder Schußfäden aufweist. Elektrische Verbindungsverfahren der elektrischen Leitern des textilen Materials 30 mit jeweiligen Leiterbahnen eines Flexbandes bzw. den Metalldrähten 20 sind ausführlich in der deutschen Patentanmeldung DE 101 61 527.2 dargestellt. Zur elektrischen Verbindung mit den Leitern 32 des textilen Materials 30 werden die Metalldrähte 20 entsprechend der benötigten Längen gekürzt. Die Seite, auf welcher die Verbindungspunkte 34 gesetzt werden, wird vorzugsweise derart gewählt, daß das textile Material 30 im Kleidungsstück die Verbindungspunkte 34 abdeckt und so einen zusätzlichen mechanischen Schutz bietet.

Mit dem erfindungsgemäßen Verfahren zur Integration von Elektronik in Textilien gelingt es, elektronische Bauelemente und integrierte Schaltkreise fest und waschbar in eine textile Umgebung zu integrieren und dabei sowohl den Anforderungen der Elektronik (Wasser- und Staubdichtigkeit, gezielte elektrische Verbindungen und isolierende Bereiche, Druck- und Knickschutz), als auch den Anforderungen der Textilien (atmungsaktiv, saugfähig, flexibel, geruchsneutral, antiallergen, gesundheitlich unbedenklich) Rechnung zu tragen. Textile Gewebe mit eingewebten leitfähigen Fasern und Drähten sind von verschiedenen Herstellern erhältlich. Derzeit werden sie hauptsächlich als modische Effektgewebe, in Antistatik-Bekleidung und zur Strahlungsabschirmung verwendet. Um die eingewebten feinen, flexiblen Metallfäden in dem textilen Gewebe als elektrische Verbindung nutzen zu können, muß bei der Gewebeherstellung darauf geachtet werden, daß in dem die Leiter umgebenden isolierenden Schutzlack keine Beschädigungen auftreten, welche in einem feuchten Gewebezustand zu elektrischen Kurzschlüssen führen könnten.

### Bezugszeichenliste

- 8, 8': elektronisches Bauelement
- 10: Leiterplatte
- 14: passive Komponenten des Bauelements
- 16: aktive Komponenten des Bauelements
- 18: Kontaktstellen
- 20: Metalldrähte
- 22: erste Kapselung
- 24: zweite Kapselung
- 26: textile Abdeckung
- 28: integrierten Schaltkreis
- 30: textiles Material, Gewebe
- 32: Leiter in dem textilen Material
- 34: Verbindungspunkte Metalldraht zu Leiter

## Patentansprüche

1. Vorrichtung mit
- zumindest einem textilen Material (30), in welchem zumindest ein flexibler, draht- und/oder fadenartiger elektrischer Leiter (32) angeordnet ist;
- zumindest einem elektronischen Bauelement (8, 8'), welches zumindest eine elektrisch leitfähige Kontaktstelle (18) aufweist, die mit dem Leiter (32) elektrisch verbunden ist;
- zumindest einer ersten harten Kapselung (22), welche zumindest die Kontaktstelle (18) des Bauelements (8, 8') abdeckt und mechanisch stabilisiert; und
- zumindest einer zweiten Kapselung (24), welche derart ausgelegt ist, daß sie eine mechanische Verbindung des Bauelements (8, 8') mit dem textilen Material (30) ermöglicht, **dadurch gekennzeichnet, daß**
die zweite Kapselung (24) ein Silikon, ein Polyurethan und/oder einen Textilkleber, vorzugsweise einen Schmelzkleber, insbesondere einen Schmelzkleber auf Copolyamid- oder Copolyesterbasis umfaßt.

2. Vorrichtung nach Anspruch 1, wobei die erste Kapselung (22) das Bauelement (8, 8') vollständig umgibt.

3. Vorrichtung nach Anspruch 1 oder 2, wobei die zweite Kapselung (24) das Baulement (8, 8') mit der ersten Kapselung (22) vollständig umgibt.

4. Vorrichtung nach einem der vorangegangenen Ansprüche, wobei das elektronische Bauelement (8, 8') über ein Flexband mit dem Leiter (32) elektrisch verbunden ist.

5. Vorrichtung einem der Ansprüche 1 bis 3, wobei das elektronische Bauelement (8, 8') über einen flexiblen Metalldraht (20) mit dem Leiter (32) elektrisch verbunden ist.

6. Vorrichtung nach Anspruch 5, wobei der Metalldraht (20) einen Durchmesser im Bereich von 50µm bis 200µm aufweist.

7. Vorrichtung nach Anspruch 5 oder 6, wobei der Metalldraht (20) eine Isolierummantelung aufweist.

8. Vorrichtung nach Anspruch 7, wobei die Isolierummantelung eine Schmelz- bzw. Zersetzungstemperatur aufweist, welche niedriger als eine typische Löttemperatur, insbesondere niedriger als 350°C ist.

9. Vorrichtung nach Anspruch 5 bis 8, wobei der Metalldraht (20) ein Fädeldraht ist.

10. Vorrichtung nach einem der vorangegangenen Ansprüche, wobei die erste harte Kapselung (22) einen Zweikomponentenlack, einen Polyesterlack oder - kleber, einen PU-Lack, einen Globetop, einen Spritzkunststoff und/oder einen hochschmelzenden Schmelzkleber umfaßt.

11. Vorrichtung nach einem der vorangegangenen Ansprüche, wobei die zweite Kapselung (24) einen Schmelzkleber umfaßt, dessen Schmelztemperatur niedriger als die Schmelztemperatur der ersten harten Kapselung (22) und höher als eine zugelassenene Pflegetemperatur des textilen Materials (30) ist.

12. Vorrichtung nach einem der vorangegangenen Ansprüche, wobei das texile Material (30) ein Gewebe mit zumindest einem elektrisch leitfähigen Schuß- und/oder Kettfaden aufweist und der Leiter (32) zumindest einen elektrisch leitfähigen Schuß- und/oder Kettfaden des Gewebes (30) umfaßt.

13. Verfahren zum Verbinden eines elektronischen Baulements (8, 8') mit einem textilen Material (30) mit den Schritten:
- Bereitstellen zumindest eines elektronischen Bauelements (8, 8'), welches zumindest eine elektrisch leitfähige Kontaktstelle (18) aufweist;
- elektrisches Verbinden der Kontaktstelle (18) mit einer Leiterbahn eines Flexbandes oder mit einem flexiblen Metalldraht (20);
- Anbringen zumindest einer ersten harten Kapselung (22) an das Bauelement (8, 8') derart, daß zumindest die Kontaktstelle (18) des Bauelements (8, 8') abdeckt und mechanisch stabilisiert wird;
- Anbringen zumindest einer zweiten Kapselung (24) an das Bauelement (8, 8') und/oder die erste Kapselung (22);
- mechanisches Verbinden des Bauelements (8, 8') mittels der zweiten Kapselung (24) an einem textilen Material (30), in welchem zumindest ein flexibler, draht- und/oder fadenartiger elektrischer Leiter (32) angeordnet ist; und
- elektrisches Verbinden der Leiterbahn des Flexbandes bzw. des Metalldrahts (20) mit dem draht- und/oder fadenartigen elektrischen Leiter (32),
**dadurch gekennzeichnet, daß**
die zweite Kapselung (24) ein Silikon, ein Polyurethan und/oder einen Textilkleber, vorzugsweise einen Schmelzkleber, insbesondere einen Schmelzkleber auf Copolyamid- oder Copolyesterbasis umfaßt.

## Claims

1. Apparatus having
- at least one textile material (30) in which at least one flexible, wire-like and/or thread-like electric conductor (32) is arranged;
- at least one electronic component (8, 8') which has at least one electrically conductive contact point (18) which is connected electrically to the conductor (32);
- at least a first hard encapsulation (22) which covers and mechanically stabilizes at least the contact point (18) of the component (8, 8'); and
- at least a second encapsulation (24), which is designed in such a way that it permits a mechanical connection of the component (8, 8') to the textile material (30), **characterized in that**
the second encapsulation (24) comprises a silicone, a polyurethane and/or a textile adhesive, preferably a hot melt adhesive, in particular a hot melt adhesive based on copolyamide or copolyester.

2. Apparatus according to claim 1, **characterized in that** the first encapsulation (22) surrounds the component (8, 8') completely.

3. Apparatus according to claim 1 or 2, **characterized in that** the second encapsulation (24) surrounds the component (8, 8') with the first encapsulation (22) completely.

4. Apparatus according to one of the preceding claims, **characterized in that** the electronic component (8, 8') is connected electrically to the conductor (32) via a flexible ribbon.

5. Apparatus according to one of claims 1 to 3, **characterized in that** the electronic component (8, 8') is connected electrically to the conductor (32) via a flexible metal wire (20).

6. Apparatus according to claim 5, **characterized in that** the metal wire (20) has a diameter in the range from 50 µm to 200 µm.

7. Apparatus according to claim 5 or 6, **characterized in that** the metal wire (20) has an insulating sheath.

8. Apparatus according to claim 7, **characterized in that** the insulating sheath has a melting or decomposition temperature which is lower than a typical soldering temperature, in particular lower than 350°C.

9. Apparatus according to claims 5 to 8, **characterized in that** the metal wire (20) is a braided wire.

10. Apparatus according to one of the preceding claims, **characterized in that** the first hard encapsulation (22) comprises a two-component varnish, a polyester varnish or adhesive, a PU varnish, a globetop, an injection molding plastic and/or a high melting point hot melt adhesive.

11. Apparatus according to one of the preceding claims, **characterized in that** the second encapsulation (24) comprises a hot melt adhesive whose melting temperature is lower than the melting temperature of the first hard encapsulation (22) and higher than a permitted care temperature of the textile material (30).

12. Apparatus according to one of the preceding claims, **characterized in that** the textile material (30) comprises a fabric having at least one electrically conductive weft and/or warp thread, and the conductor (32) comprises at least one electrically conductive weft and/or warp thread of the fabric (30).

13. Method for connecting an electronic component (8, 8') to a textile material (30), comprising the steps:
- providing at least one electronic component (8, 8') which has at least one electrically conductive contact point (18);
- connecting the contact point (18) electrically to a conductor track of a flexible ribbon or to a flexible metal wire (20);
- applying at least a first hard encapsulation (22) to the component (8, 8') in such a way that at least the contact point (18) of the component (8, 8') is covered and mechanically stabilized;
- applying at least a second encapsulation (24) to the component (8, 8') and/or the first encapsulation (22);
- mechanically connecting the component (8, 8') by means of the second encapsulation (24) to a textile material (30) in which at least one flexible, wire-like and/or thread-like electric conductor (32) is arranged; and
- connecting the conductor track of the flexible ribbon or the metal wire (20) electrically to the wire-like and/or thread-like electric conductor (32), **characterized in that**
the second encapsulation (24) comprises a silicone, a polyurethane and/or a textile adhesive, preferably a hot melt adhesive, in particular a hot melt adhesive based on copolyamide or copolyester.

## Revendications

1. Dispositif qui présente :
- au moins un matériau textile (30) dans lequel est disposé au moins un conducteur électrique (32) flexible en forme de fil ou de fil multibrins,
- au moins un composant électronique (8, 8') qui présente au moins un emplacement (18) de contact électriquement conducteur qui est relié électriquement au conducteur (32),
- au moins une première capsule dure (22) qui recouvre au moins l'emplacement de contact (18) du composant (8, 8') et le stabilise mécaniquement et
- au moins une deuxième capsule (24) conçue de manière à relier mécaniquement le composant (8, 8') avec le matériau textile (30),
**caractérisé en ce que**
la deuxième capsule (24) comprend une silicone, un polyuréthane et/ou un adhésif textile, de préférence un adhésif à l'état fondu et en particulier un adhésif à l'état fondu à base de copolyamide ou de copolyester.

2. Dispositif selon la revendication 1, dans lequel la première capsule (22) entoure complètement le composant (8, 8').

3. Dispositif selon les revendications 1 ou 2, dans lequel la deuxième capsule (24) englobe complètement le composant (8, 8') et la première capsule (22).

4. Dispositif selon l'une des revendications précédentes, dans lequel le composant électronique (8, 8') est relié électriquement au conducteur (32) au moyen d'un ruban flexible.

5. Dispositif selon l'une des revendications 1 à 3, dans lequel le composant électronique (8, 8') est relié électriquement au conducteur (32) par un fil métallique flexible (20).

6. Dispositif selon la revendication 5 dans lequel le fil métallique (20) a un diamètre compris dans la plage de 50 µm à 200 µm.

7. Dispositif selon les revendications 5 ou 6, dans lequel le fil métallique (20) présente une enveloppe isolante.

8. Dispositif selon la revendication 7, dans lequel l'enveloppe isolante présente une température de fusion ou de décomposition inférieure à une température typique de brasage tendre et en particulier inférieure à 350° C.

9. Dispositif selon les revendications 5 à 8, dans lequel le fil métallique (20) est un fil multibrins.

10. Dispositif selon l'une des revendications précédentes, dans lequel la première capsule dure (22) comprend un vernis à deux composants, un vernis ou un adhésif au polyester, un vernis au PU, un "sommet bombé", une matière synthétique moulée par injection et/ou un adhésif à haut point de fusion.

11. Dispositif selon l'une des revendications précédentes, dans lequel la deuxième capsule (24) comprend un adhésif à l'état fondu dont la température de fusion est inférieure à la température de fusion de la première capsule dure (22) et plus supérieure à la température admissible de soins du matériau textile (30).

12. Dispositif selon l'une des revendications précédentes, dans lequel le matériau textile (30) présente un tissu qui présente au moins un fil de trame et/ou un fil de chaîne électriquement conducteur, le conducteur (32) comprenant au moins un fil de trame et/ou un fil de chaîne électriquement conducteur du tissu (30).

13. Procédé pour relier un composant électronique (8, 8') à un matériau textile (30), lequel procédé comprend les étapes qui consistent à :
- préparer au moins un composant électronique (8, 8') qui présente au moins un emplacement (18) de contact électriquement conducteur,
- relier électriquement l'emplacement de contact (18) à une piste conductrice d'un ruban flexible ou à un fil métallique flexible (20),
- appliquer au moins une première capsule dure (22) sur le composant (8, 8') de telle manière qu'au moins l'emplacement de contact (18) du composant (8, 8') soit recouvert et stabilisé mécaniquement,
- appliquer au moins une deuxième capsule (24) sur le composant (8, 8') et/ou sur la première capsule (22),
- relier mécaniquement le composant (8, 8') au moyen de la deuxième capsule (24) à un matériau textile (30) dans lequel au moins un conducteur électrique flexible (32), en forme de fil et/ou ou de fil multibrins est disposé et
- relier électriquement la piste conductrice de ruban flexible ou le fil métallique (20) au conducteur électrique (32) en forme de fil et/ou de fil multibrins,
**caractérisé en ce que**
la deuxième capsule (24) comprend une silicone, un polyuréthane ou un adhésif textile, de préférence un adhésif à l'état fondu et en particulier un adhésif à l'état fondu à base de copolyamide ou de copolyester.
